# EUROPEAN PATENT APPLICATION

(11) **EP 2 804 322 A1**
(43) Date of publication of application: **19.11.2014**
(21) Application number: 14168187.4
(22) Date of filing: 13.05.2014
(51) Int. Cl.: H03L 7/081, H04L 7/033, H03L 7/07

(54) **Systems and methods for tracking a received data signal in a clock and data recovery circuit**

(30) Priority: 13.05.2013 US 201313893275
(71) Applicant: Adeptence, LLC, Culver City, CA 90232 (US)
(72) Inventor: Lakkis, Ismail, San Diego, CA California CA 92008 (US)
(74) Representative: Keane, Paul Fachtna

(57) **Abstract**

A clock a data recovery circuit (CDR) operates recovers data from a serial input signal. The CDR uses oversampling to sample the serial input signal at multiple phases. The multiple phases are generated from a reference clock that is not locked to the data rate of the serial input signal. A maximum of two phases are used at a time. The resulting CDR provides high performance while having low power consumption.

## Description

### BACKGROUND

### Technical Field

The embodiments described herein relate to clock and data recovery circuits.

### Related Art

In, e.g., communication applications, processing circuitry often processes data in a parallel manner, but the data are often communicated between points serially. Data may be transmitted serially over channels such as circuit board traces, backplanes, or fiber optic cables. A transmitter for serial communication can transmit data in a data signal with clocking information signaled implicitly by the timing of transitions in the data signal. A receiver recovers both the transmitted data and a corresponding clock signal. Circuitry in the receiver performing such operations is often termed a clock and data recovery circuit or more commonly a CDR.

Many clock and data recovery circuits operate using critical analog or quasi-analog circuits such as voltage-controlled oscillators, phase-frequency detectors, charge pumps, and filters. Such circuits can be difficult to develop and manufacture. Additionally, desires for higher speeds and reduced cost and power increase the difficulties in developing and manufacturing CDRs.

One problem with conventional CDRs is the difficulty of matching the receiver operation to that of the transmitter. The problem arises due to the fact that the clock circuitry in the transmitter and receiver will not operate at the exact same frequency due to manufacturing tolerances. Moreover, each of the clocks in the transmitter and receiver will drift over time at different rates. Accordingly, it is very difficult to keep the operation of the receiver and the transmitter locked to each other and some active operation is typically needed to ensure that the two remain locked.

A conventional technique is to over sample the data signal received in the receiver using multiple phases of the receiver clock. This allows control circuitry in the receiver to "map" the received data signal and determine the optimum point, and corresponding phase at which to sample the received signal. It will be understood that conventionally, at least 3 phases per bit must be used in such an over sampling scheme; however, this increases the complexity, size, and cost of the receiver.

### SUMMARY

Systems and methods for detecting recovering a data and clock signal in a communication system are described herein.

In one aspect, a data recovery circuit, comprises a first flip-flop configured to store values of a serial input signal at times signaled by a first sample signal; a second flip-flop configured to store values of the serial input signal at times signaled by a second sample signal; a phase select module configured to produce the first sample signal and the second sample signal, the first sample signal and the second sample signal oscillating at a frequency matching an expected data rate of the serial input signal and having phases with selected offsets; and a control module configured to produce an output data signal from only the values from the first flip-flop and the second flip-flop, and to control the phase select module to produce the first sample signal and the second sample signal to recover data from the serial input signal.

In another aspect, a data recovery circuit, comprises a first flip-flop configured to produce a first data sample signal by storing values of a serial input signal at edges of a first sample signal; a second flip-flop configured to produce a second data sample signal by storing values of the serial input signal at edges of a second sample signal; a phase select module configured to produce the first sample signal by selecting one of plurality of phase signals according to a first phase control signal and produce the second sample signal by selecting one of the plurality of phase signals according to a second phase control signal, each of the plurality of phase signals offset in phase and oscillating at a frequency corresponding to the data rate of the serial input signal; an accumulate module configured to accumulate counts of miscompares between values of the first data sample signal and the second data sample signal; a data selector configured to produce an output data signal by selecting the first data sample signal or the second data sample signal according to a data select control signal; and a control module configured to produce the first phase control signal, the second phase control signal, and the data select control signal using the accumulated counts of miscompares so that the output data signal signals data recovered from the serial input signal, wherein only the first flip-flop and the second flip-flop store values of the serial input signal.

Other features and advantages of the present invention should be apparent from the following description which illustrates, by way of example, aspects of the invention.

### BRIEF DESCRIPTION OF THE DRAWINGS

The details of the present invention, both as to its structure and operation, may be gleaned in part by study of the accompanying drawings, in which like reference numerals refer to like parts, and in which:
FIG. 1 is a block diagram of a clock and data recovery circuit in accordance with aspects of the invention;
FIG. 2 is a timing diagram illustrating operation of a clock and data recovery circuit in accordance with aspects of the invention;
FIG. 3 is a block diagram of a clock and data recovery circuit in accordance with aspects of the invention;
FIG. 4 is a block diagram of a communication system in accordance with aspects of the invention;
FIG. 5 is a block diagram illustrating an example circuit for generating a serial communication signal;
FIG. 6 is a block diagram illustrating an example PLL circuit that can be used in the system of FIG. 1 in accordance with one embodiment;
FIG. 7A is a diagram illustrating a basic ring oscillator comprising a simple inverter that can be used in the PLL circuit of FIG. 6;
FIG. 7B is a diagram illustrating a ring oscillator comprising multiple inverters;
FIG. 7C is a diagram illustrating the outputs of the various stages of the multi-inverter ring oscillator of FIG. 7B;
FIG. 8 is a diagram illustrating a typical LC oscillator that can be used in the PLL circuit of FIG. 6;
FIG. 9 is a diagram illustrating an example communication system that deploys multiple communication channels according to one embodiment; and
FIG. 10 6 is a block diagram illustrating an example PLL circuit that can be used in the system of FIG. 9 in accordance with one embodiment.

### DETAILED DESCRIPTION

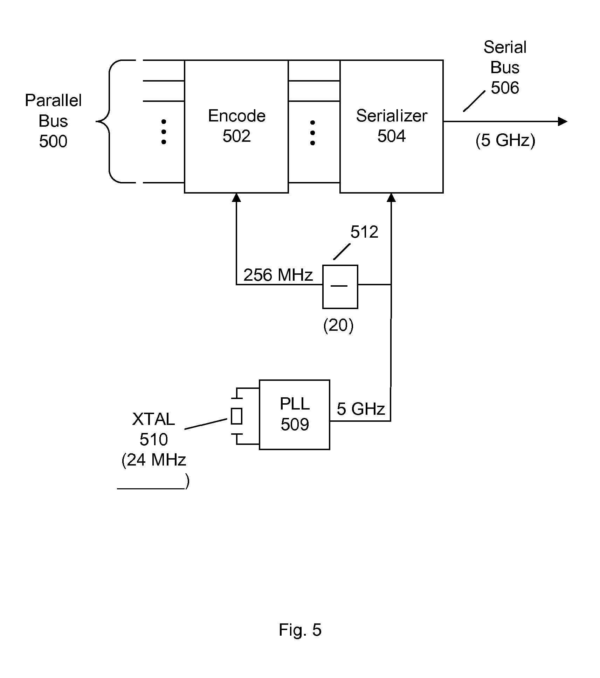

FIG. 5 is a block diagram illustrating an example circuit for generating a serial communication signal. A can be seen, the data start out as parallel data on parallel data bus 500. For example, serial data bus 500 can be a 16 bit parallel data bus. The parallel data can be encoded into, e.g., 20 bits of parallel data, e.g., in encoder 502. This, e.g., 20 bit parallel data can then be converted to a serial data signal by serializer 504, which can for example comprise a multiplexer or MUX. The serial data can then be sent to serial data bus 506 for transmission.

In this example, the serial data on serial data bus 506 can have a data rate of 5GHz. Accordingly, serializer 504 can be controlled by a 5GHz clock signal generated by Phase Locked Loop (PLL) 508. Encoder 502 will then operate at 256MHz (5GHz/20bits). Accordingly, a divider 512 can be configured to divide the 5GHz clock signal down to 256MHz in order to generate a clock signal that can control the operation of encoder 502.

PLL operation is discussed in more detail below, but it will be understood that a crystal 510 is required to generate a reference signal for PLL 508. Such a crystal can be configured to generate a reference frequency, e.g., 24MHz, but such crystals will also have a manufacturing tolerance of, e.g., 500 ppm. Thus, a given crystal will not typically oscillate at exactly 24MHz.

A corresponding receiver will operate in reverse, e.g., the transmitted serial signal will be received, de-serialized, and decoded. Thus, a PLL circuit will be needed in the receiver in order to generate clock signals to perform these operations. But the PLL circuit in the receiver will likely not generate a clock signal at exactly the same frequency as that in the transmitter due toe the manufacturing tolerance and also due to drift as noted above. As a result, some form of Clock and Data Recover (CDR) circuit is needed in order to synchronize the receiver operation with that of the transmitter and to maintain that synchronization.

Over sampling the received signal is often used in conventional CDR circuits. This involves sampling the received signal at multiple points in order to clearly identify the rising and falling edges of the data signal. But conventional over sampling circuits typically require at least 3 samples per bit, which increases the complexity of the CDR circuit.

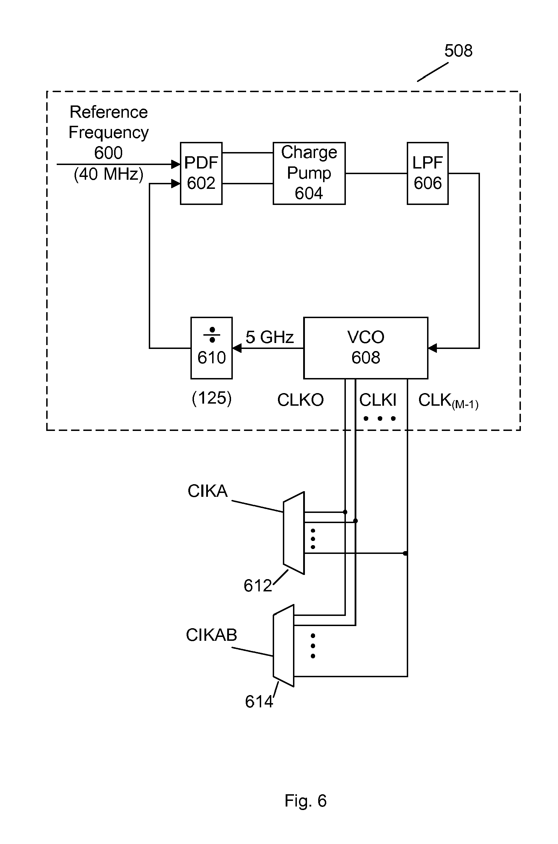

CDR circuits configured in accordance with the systems and methods described herein are discussed in detail below. But first, FIG. 6 is a block diagram illustrating an example PLL circuit 508 in more detail. A PLL is a control system that generates an output signal whose phase is related to the phase of an input "reference" signal. Thus, it is an electronic circuit consisting of a variable frequency oscillator and a phase detector. The circuit compares the phase of the input reference signal with the phase of a signal derived from its output oscillator and adjusts the frequency of its oscillator to keep the phases matched. The signal from the phase detector is used to control the oscillator in a feedback loop.

Frequency is the time derivative of phase. Keeping the input and output phase in lock step implies keeping the input and output frequencies in lock step. Consequently, a phase-locked loop can track an input frequency, or it can generate a frequency that is a multiple of the input frequency.

As can be seen in FIG. 6, a reference voltage, in this case 40MHz, and a feedback signal are provided to a Phase-Frequency-Detector (PFD) circuit 602. PFD 602 detects errors between the reference signal and the feedback signal. The output of PFD 602 is then used to control the feedback operation and is provided to charge pump 604. The output of charge pump 604 is then provide to Low Pass Filter (LPF) 606, which averages the signals from charge pump 606 and provides the averaged signal as an input to Voltage Controlled Oscillator (VCO) 608, which is configured to generate a clock signal at the desired frequency, e.g., 5GHz. Thus, in this example, the PLL 508 is used to produce a clock signal that is a multiple of the reference signal.

This clock signal is then divided down to, e.g., 40MHz, by divider circuit 610. In addition, VCO 608 can be configured to generate multiple phases of the clock signal, e.g., CLK 1, CLK 2, ..., CLK (n-1), which can be used to generate two clock signals, CLKA and CLKB, in accordance with the embodiments described below.

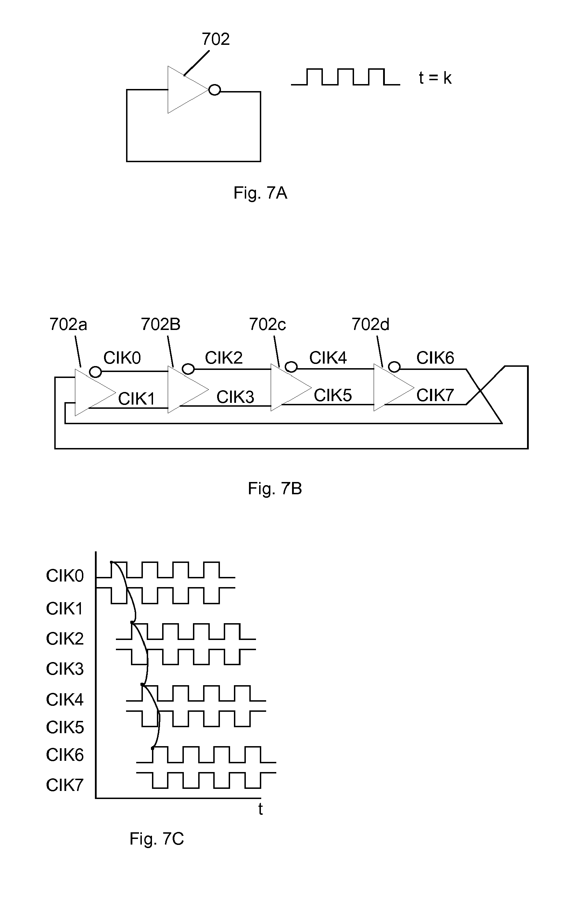

VCO 608 can, e.g., use either a ring oscillator or a LC oscillator. FIG. 7A is a diagram illustrating a basic ring oscillator comprising a simple inverter 702. A ring oscillator is a device composed of an odd number of inverter gates whose output oscillates between two voltage levels. Thus, the circuit of FIG. 7A would produce the output signal illustrated. As noted, a typical ring oscillator will comprise multiple inverters, which can be used to generate the multiple phases. The inverters are attached in a chain; the output of the last inverter is fed back into the first inverter as illustrated in FIG. 7B. The delay times associated with each inverter will delay the subsequent inverter outputs relative to the inputs and thus create the different phases as illustrated in FIG. 7C.

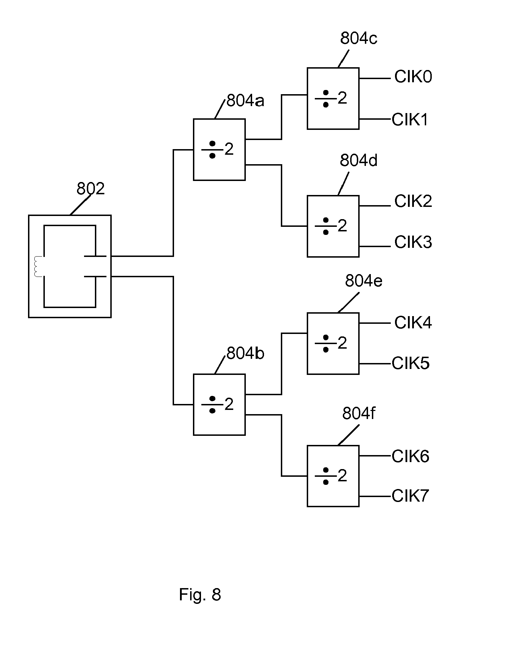

FIG. 8 is a diagram illustrating a typical LC oscillator. An LC circuit, also called a resonant circuit, tank circuit, or tuned circuit, consists of an inductor, represented by the letter L, and a capacitor, represented by the letter C. When connected together, they can act as an electrical resonator, an electrical analogue of a tuning fork, storing energy oscillating at the circuit's resonant frequency. LC circuits are used either for generating signals at a particular frequency, or picking out a signal at a particular frequency from a more complex signal.. Multiple phases can be generated using divider circuits 804a-f.

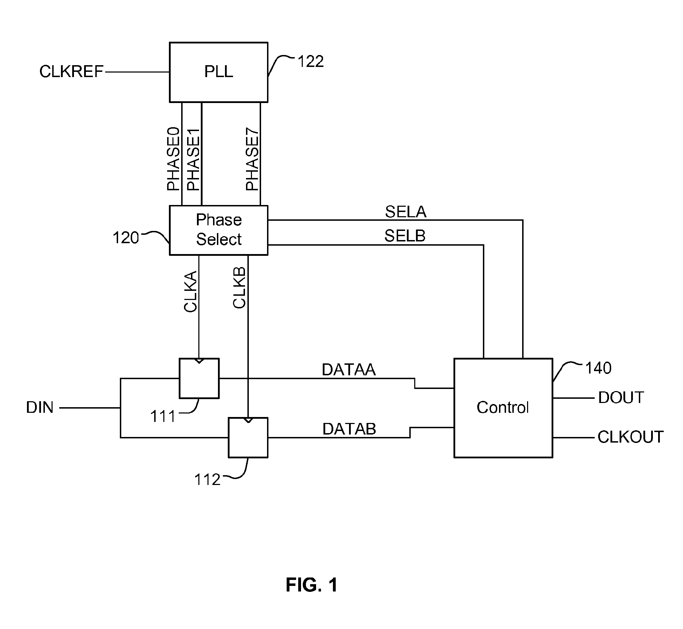

With the above in mind, FIG. 1 is a block diagram of a CDR in accordance with aspects of the invention. The circuit receives a serial input signal DIN that conveys a sequential stream of data bits from which is produced an output data signal DOUT. The circuit operates to produce the output data signal so that values in the output data signal substantially match values sent by a transmitter used to produce the serial input signal. The circuit may also produce an associated output clock signal CLKOUT that is synchronized with the output data signal. When operation of the circuit is synchronized to the serial input signal, it is said to be locked. The circuit adjusts its operation to match the rate at which data are received. The data rate may vary gradually over time, for example, changing by tens of parts per million, and when the circuitry is locked it tracks such timing changes. Blocks of the circuitry are generally implemented with semiconductor electronics and, for example, may be provided as a CMOS integrated circuit.

The clock and data recovery circuit includes a first input flip-flop 111 and a second input flip-flop 112. The first input flip-flop 111 stores values of the serial input signal on rising edges of a first sample clock signal CLKA to produce a first data sample signal DATAA. The second input flip-flop 112 stores values of the serial input signal on rising edges of a second sample clock signal CLKB to produce a second data sample signal DATAB. By analogy to analog sample-and-hold circuit terminology, the input flip-flop may be considered to sample the serial input signal at times triggered by the associated sample clock signal and to hold the sampled values between sample times.

The sample clock signals are produced by a phase select module 120. The phase select module 120 receives phase signals PHASEO-PHASE7 that oscillate at the same frequency but have different relative phases. The phase signals may be generated by buffering signals from the various stages of a multi-stage ring oscillator. For example, there may be eight phase signals oscillating at 5 GHz and spaced by 45°. The phase select module 120 selects one of the phase signals to output as the first sample clock signal based on a first phase control signal SELA. The phase select module 120 selects one of the phase signals to output as the second sample clock signal based on a second phase control signal SELB. It will be understood that more or less phase signals can be used depending on the embodiment.

The phase signals are supplied by a phase-locked loop 122. The phase-locked loop 122 receives a reference clock signal CLKREF. The reference clock signal oscillates at a frequency corresponding to the expected data of the serial input signal. The frequency of the reference clock signal may be a sub-multiple of the data rate. For example, when the nominal data rate is 5 Gbps and the frequency of the reference clock signal may be 250 MHz. Although the phase signals oscillate at a frequency that nominally matches the expected data rate, the phases signals are not necessary locked to the data rate and the frequency of the phase signals may vary from the expected data rate. The frequency variation may be due to a tolerance, for example, 100 parts per million, in a crystal used to generate the reference clock signal. Additionally, the actual received data rate may vary from the expected data rate due to frequency tolerances at the transmitter.

A control module 140 receives and analyzes the data sample signals to produce the phase control signals. The control module 140 produces the output data signal by selecting one of the data sample signals. In the embodiment illustrated in FIG. 1, the control module 140 also produces the output clock signal. The control module may produce the output clock signal by selecting the one of the sample clock signals corresponding to the selected data sample signal.

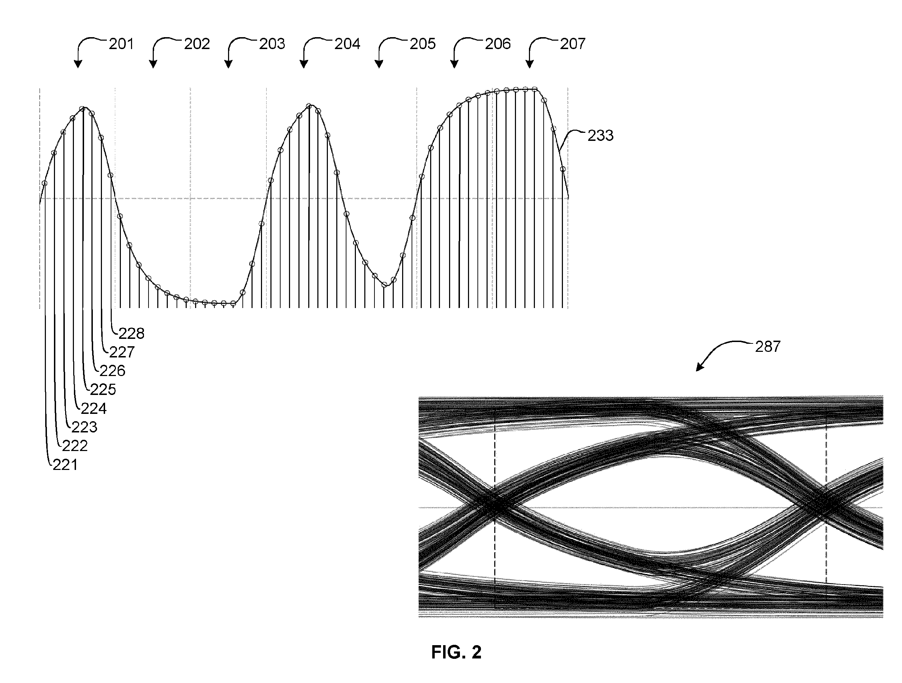

Further understanding of the operation of the clock and data recovery circuit may be gleaned by reference to FIG. 2, which is a timing diagram illustrating operation of a clock and data recovery circuit. Seven bit intervals 201-207 of an example serial input signal 233 are shown. Sample values corresponding each of eight phases 221-228 are also shown. It is common to describe serial data signals by reference to eye diagrams, which show multiple waveforms for different bit intervals overlaid. FIG. 2 shows an example eye diagram 287. It is apparent from the example eye diagram 287 and the example serial input signal 233 that sampling the serial input signal near the center of the eye and away from the edges or signal transitions will increase the likelihood of producing correct data values.

Although the serial input signal may begin as a binary signal with instantaneous transitions between levels, it becomes distorted by its communication channel and limitations of its transmitter. For example, limited bandwidth of the channel and transmitter can cause intersymbol interference. Additionally, the serial data signal may be distorted by noise and jitter.

The CDR determines the clock phase to sample the serial input signal that provides reliable data recovery. Since phase and frequency are integrally related, updating the sampling phase can effectuate a change in sampling frequency. The control module 140 generally operates to control the first sample clock signal so that the first input flip-flop 111 samples the serial input signal at the center of the data eye. Operation of the control module 140 includes comparing the data sample signals and setting the phase control signals based on how often the data sample signals are equal for different phases. Operation of the control module 140 includes an acquisition stage and a tracking stage.

The control module 140, in the clock and data recovery circuit of FIG. 1, may search for a good sample phase by setting the phase control signals to select consecutive pairs of the phase signals. For example, the first sample clock signal and the second sample clock signal may be set one of the combinations listed in the table below.

| first sample clock signal (CLKA) | second sample clock signal (CLKB) |
|---|---|
| first phase signal (PHASE0) | second phase signal (PHASE1) |
| second phase signal (PHASE1) | third phase signal (PHASE2) |
| third phase signal (PHASE2) | fourth phase signal (PHASE3) |
| fourth phase signal (PHASE3) | fifth phase signal (PHASE4) |
| fifth phase signal (PHASE4) | sixth phase signal (PHASE5) |
| sixth phase signal (PHASE5) | seventh phase signal (PHASE6) |
| seventh phase signal (PHASE6) | eighth phase signal (PHASE7) |
| eighth phase signal (PHASE7) | first phase signal (PHASE0) |

When both of the sample clock signals are near the center of the data eyes, the data sample signals can be expected to have the same values. Similarly, when the sample clock signals are on opposite sides of the edges of the data eyes, the data sample signals can be expected to frequently have different values. For example, for the example signals of FIG. 2, when the first sample clock signal matches the third phase signal and the second sample clock signal matches the fourth phase signal, the first and second data sample signals are the same at each bit time. In contrast, when the first sample clock signal matches the eighth phase signal and the second sample clock signal matches the first phase signal, the first and second data sample signals are different when consecutive bit intervals have different data values.

The control module 140 may perform the acquisition stage by measuring how often the data sample signals are different for the various combinations of phases. The control module 140 can then use the collected measurements to determine a desired phase for operation of the clock and data recovery circuit. The acquisition stage can begin by setting the phase select signals to a first one of the combinations of consecutive pairs and accumulating the number of times the first and second first data sample signals are different over a number of bit times. For example, the control module 140 may initially cause the serial input signal to be sampled at the first and second phases while accumulating the number of miscompares over 64 bit times. The control module 140 may then repeat the accumulating of miscompares for each combination of phases.

The control module 140 may determine which phase is at the edges of the data eyes and select a phase offset by one half bit time from the edges for use in data recovery. Alternatively, the control module 140 may determine which phase is at the centers of the data eyes and select the corresponding phase for use in data recovery. Various statistical measures may be used to determine the phases associated with the eye edges or centers. For example, the eye edge may be taken as the phase at which the number of measured miscompares is a maximum. Alternatively, the eye edge may be taken as the phase at the middle of a range of phases for which the number of measured miscompares is large. The number of miscompares that is large can be relative to the probability of data transitions in the serial input signal. Corresponding techniques may be used to find the phase of the eye center.

For the example table of phases and miscompares below, the eye edge may be taken at the maximum (between second and third phases) or the middle of the large values (between third and fourth phases). Similarly, the eye center may be taken as the middle of the phases with zero (or a small amount) of miscompares (between seventh and eighth phases). Accordingly, the seventh phase may be selected for data recovery.

| Phase combination | Number of miscompares |
|---|---|
| first and second phases | 5 |
| second and third phases | 33 |
| third and fourth phases | 32 |
| fourth and fifth phases | 24 |
| fifth and sixth phases | 4 |
| sixth and seventh phases | 1 |
| seventh and eighth phases | 0 |
| eighth and ninth phases | 0 |

The clock and data recovery circuit begins recovering data using the phase determined in the acquisition stage. The timing of the serial input signal relative to the phase signals may change over time, for example, due to delay changes or more commonly frequency differences between the clock used to transmit the data the reference clock used to generate the phase signals. When, for example, the frequencies differ by 100 parts per million and there are eight sample phases, the serial input signal will shift by one phase in 1250 bit times. The control module 140 uses a tracking stage to adjust the sample clock signals to the timing of the serial input signal.

The control module 140 can use various comparisons of the data sample signals in the tracking stage. The control module 140 may, when using the first sample clock signal for data recovery, set the second sample clock signal to the phase offset from the phase of the first sample clock signal by one half of a bit interval. The second clock signal, e.g., CLKB, can then be used for monitoring and control by control module 140 in order to detect when PLL 122 has drifted significantly enough that the phase signal used for data recovery is no longer appropriate.

Alternatively, the control module 140 may set the second sample clock signal (when using the first sample clock signal for data recovery) to a phase offset from the phase of the first sample clock signal by less than one half a bit interval and accumulate miscompares of the resulting data sample signals. For example, control module 140 may alternate between setting the second sample clock signal to the phases that are advanced or retarded from the phase of the first sample clock signal by one quarter of a bit interval.

Thus, once, e.g., once a pahse signal is selected and CLKA is set for data recovery, and a second phase is selected and CLKB is set monitoring, the resulting sample signals DATAA and DATAB can be compared. For example, the sample signals can be Exlcusive-ORed (XORed) and the results accumulated. As long as the result of the XOR operation is "1", then everything is fine; however, once the result start to include "0", tehn the control module 140 can be configured to detect that the phase of the PLL 122 is slipping and begin the process of selecting new phase signals for data recovery and monitoring.

For example, control module can be configured to shift the phase of CLKB one way or the other in order to detect which way the phase of PLL 122 is slipping and to determine what would phase signal should be used for data recovery. Once the new correct phase signal is determined, then it can be used; however, if control; module 140 were to simply switch the phase signal for CLKA, the resulting switching and recovery time would likely result in lost data. In other words, the switching and recovery time is too long. To address this issue, control module 140 can be configured to switch CLKB to the optimum phase for data recovery, while still using CLKA for data recovery. Once CLKB has settled, then control module 140 can be configured to begin using CLKB for data recovery and switch CLKA to the appropriate phase for monitoring as described above. In this way, data recovery is not impacted, the optimal phase for data recovery is maintained, and only two phase signals are used.

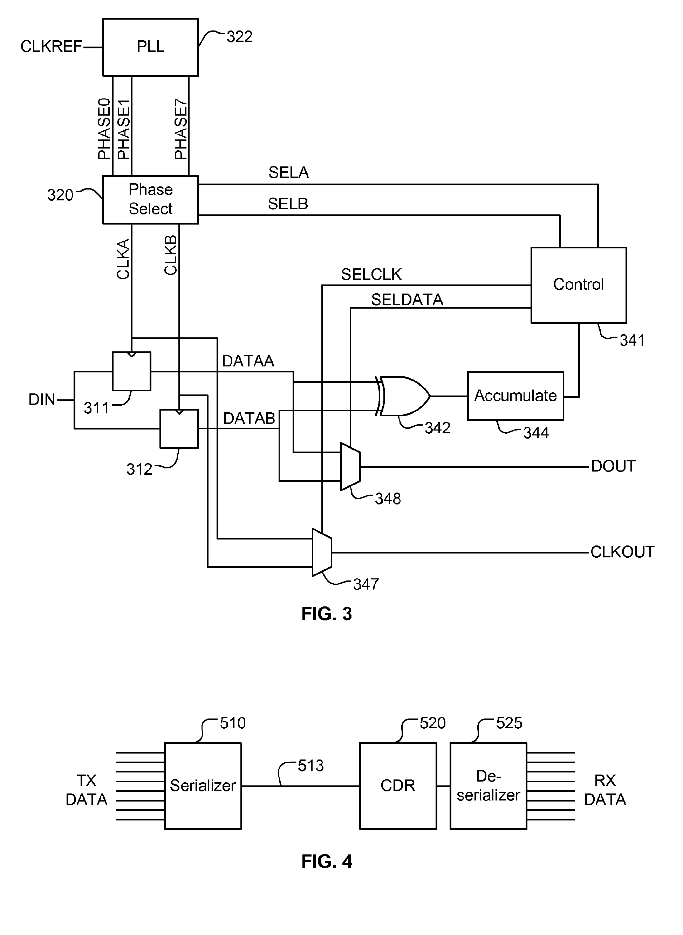

FIG. 3 is a block diagram of a clock and data recovery circuit in accordance with aspects of the invention. The clock and data recovery circuit of FIG. 3 is similar to the clock and data recovery circuit of FIG. 1. The clock and data recovery circuit of FIG. 3 may be used to implement the clock and data recovery circuit of FIG. 1.

The clock and data recovery circuit of FIG. 3 include a phase select module 320 and a phase-locked loop 322 to generate first and second sample clock signals from a reference clock signal. In some embodiments, the phase select module 320 and the phase-locked loop 322 are similar to or the same as the phase select module 120 and the phase-locked loop 122 of FIG. 1.

The clock and data recovery circuit of FIG. 3 include a first input flip-flop 311 and a second input flip-flop 312 to store values of a serial input signal on edges of the sample clock signals and produce first and second data sample signals. In some embodiments, the first input flip-flop 311 and the second input flip-flop 312 are similar to or the same as the first input flip-flop 111 and the second input flip-flop 112 of FIG. 1.

The clock and data recovery circuit of FIG. 3 include a control module 341 that controls which phase signals are used in the clock and data recovery circuit. The control module 341 also controls what output data signal and output clock signal are produced by the clock and data recovery circuit.

The first and second data sample signals are compared in an exclusive-or logic gate 342. The output of the exclusive-or logic gate 342, which is a logic zero when the data sample signals are equal and a logic one when the data sample signals differ, is accumulated in an accumulate module 344. Accumulated values from the accumulate module 344 are supplied to the control module 341 for use in setting the phases of the sample clock signals.

The clock and data recovery circuit include a first selector 348 that receives the first and second data sample signals. The first selector 348 selects one of the data sample signals to output as the output data signal. The selection is determined by a control signal from the control module 341.

The clock and data recovery circuit also includes a second selector 347 that receives the first and second sample clock signals. The second selector 347 selects one of the sample clock signals to output as the output clock signal. The selection is determined by a control signal from the control module 341. The selection by the second selector 347 commonly matches the selection by the first selector 348.

The control module 341 can control operation of the clock and data recovery circuit using techniques that are the same or similar to the techniques of the control module 140 of the clock and data recovery circuit of FIG. 1. The control module 341 of clock and data recovery circuit of FIG. 3 can use an acquisition stage to find a phase to use for clock recovery and a tracking stage to adjust the phase during continued operation.

Many variations of the illustrated clock and data recovery circuits are possible. For example, implementations of the clock and data recovery circuits can have different numbers of phases. Additionally, CDR implementations may operate at various frequencies. A CDR implementation may swap the uses of the first and second input flip-flops, the first and second data sample signals, and the first and second data sample signals. The uses may be swapped dynamically. Although the clock and data recovery circuits have been described as having events triggered by rising edges of clock signals, a CDR implementation may have signal transitions on falling edges or a combination of rising and falling edges. Furthermore, the boundaries between the described modules and functions may be modified with some functions distributed across modules or combined in one module. Similarly, some circuits may be shared between multiple modules and functions.

The illustrated clock and data recovery circuits are simplified for clarity of description. In many CDR implementations, particularly those that operate at high frequencies, some signals of the CDR use a pair of differential signal lines for each of the illustrated signals. Additional devices may be included in a CDR implementation to facilitate signal timing. For example, additional flip-flops may be used to retime the first and second data sample signals to a common clock edge. Additional flip-flops may also be added between various modules as pipeline stages, for example, to allow higher frequency operation or to reduce metastability issues. Buffer circuits may also be included to drive the various signals with timing characteristics that will provide the desired operation.

The generation of the phase signals may also differ from the illustrated embodiments. Various types of controlled-frequency oscillators may be used. For example, delay-locked loops may be used in place of or in combination with phase-locked loops. The phase select modules may also include phase interpolators to produce sub-phases between edges of the phase signals.

In some embodiments, the speed at which the sample clock signals can be modified may be limited or the sample clock signals may be briefly indeterminate when the phase is modified. Operation of the control modules may be modified accordingly. For example, when the phase used for data recovery is to be modified during tracking, the control module may switch which sample clock signal is used rather than directly switching timing of the currently used sample clock signal. For example, when the first sample clock signal is being used for data recovery and the phase is to be changed to a new phase, the second sample clock signal may be set to the new phase and the data recovery switched to the second sample clock signal after it is reliably operating.

The control modules may also use different techniques in the acquisition phase. For example, a binary search may be used rather than sweeping through all phases. Additionally, the search may be done in coarse and then fine stages to refine phase selection. The number of samples accumulated may also be dynamically varied.

The illustrated clock and data recovery circuits operate with clocks that oscillate at the data rate. Alternative implementations may use clocks that oscillate at a sub-multiple of the data rate. For example, a CDR implementation may use clocks that oscillate at a one half the data rate with circuitry using two sets of sample clock signals and data sample signals combined to produce the output data signal.

FIG. 4 is a block diagram of a communication system in accordance with aspects of the invention. Parallel data for transmission is supplied to a serializer 510 in a transmitting device. The serializer 510 converts the parallel data to a serial data stream that is communicated over a communication link 513. A clock and data recovery circuit 520 in a receiving device received the serial data stream as a serial input signal. The clock and data recovery circuit 520 may be the clock and data recovery circuit of FIG. 1 or FIG. 3. The clock and data recovery circuit 520 recovers the data from the serial input signal. The recovered data is supplied to a deserializer 525 that converts the recovered data to a parallel format. When the clock and data recovery circuit 520 is locked, the parallel data from the deserializer 525 matches parallel data supplied to the serializer 510.

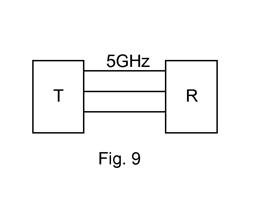

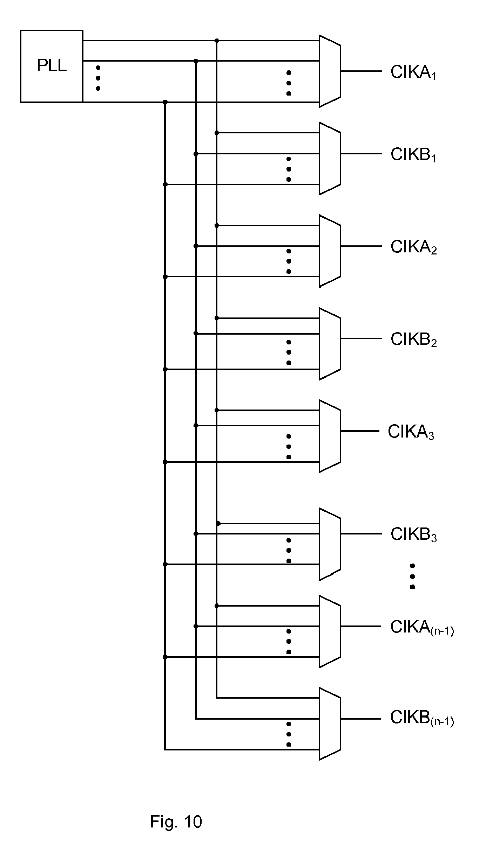

In the embodiment of FIG. 4, a single channel or lane is connected between the transmitting device and the receiving device. In certain embodiments, however multiple channels or lanes can be connected between devices as illustrated in FIG. 9. The multiple produced by the PLL can be used to generate a plurality of clock phase pairs to be used as described above. This is illustrated in the embodiment of FIG. 10. As can be seen on FIG. 10 multiple clock phase pairs CLKA and CLKB pairs can be generated and used for each of the plurality of lanes just as described above. In other embodiments, certain clock phase signals CLKA and CLKB can be used for multiple lanes. For example, CLKB1 can be used for multiple lanes.

The various illustrative blocks and modules described in connection with the embodiments disclosed herein can be implemented in various forms. Some blocks and modules have been described above generally in terms of their functionality. How such functionality is implemented depends upon the design constraints imposed on an overall system. Skilled persons can implement the described functionality in varying ways for each particular application, but such implementation decisions should not be interpreted as causing a departure from the scope of the invention. In addition, the grouping of functions within a module, block, or step is for ease of description. Specific functions or steps can be moved from one module or block without departing from the invention.

The various illustrative blocks and modules described in connection with the embodiments disclosed herein can be implemented in or with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor can be a microprocessor, but in the alternative, the processor can be any processor, controller, microcontroller, or state machine. A processor can also be implemented as a combination of computing devices, for example, a combination of a DSP and a microprocessor, a plurality of microprocessors, one or more microprocessors in conjunction with a DSP core, or any other such configuration.

The above description of the disclosed embodiments is provided to enable any person skilled in the art to make or use the invention. Various modifications to these embodiments will be readily apparent to those skilled in the art, and the generic principles described herein can be applied to other embodiments without departing from the spirit or scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly limited by nothing other than the appended claims.

Aspects and advantages of the present disclosure relate to the following numbered clauses:
1. A data recovery circuit, comprising:
   a Phase Lock Loop (PLL) configured to generate a plurality of clock phase signals;
   a phase select module configured to produce a first clock signal and a second clock signal from the plurality of clock phase signals, the first and second clock signals for use in acquiring and tracking a received data signal;
   a first sample generation block configured to generate a first sample of the received data signal under control of the first clock signals;
   a second sample generation block configured to generate a second sample of the received data signal under control of the second clock signal; and
   a control module coupled with the first and second sample generation blocks and the phase select module and configured to control the phase select module so as to iteratively produce the first and second clock signals from pairs of the plurality of clock phase signals and compare the first and second samples to acquire the received data signal and to select one of the plurality of clock phase signals as a sampling phase for use in recovering the received data signal and to select another one of the plurality of clock phase signals as a tracking phase for use in tracking the received data signal.
2. The data recover circuit of clause 1, wherein the first sample generation block is configured to generate a first sample of the received data signal under control of the sampling phase and the second sample generation block is configured to generate a second sample of the received data signal under control of the tracking phase.
3. The data recovery circuit of clause 1, wherein the control module further comprises an accumulator coupled with the first and second sample generation blocks, the accumulator configured to accumulate the results of comparisons of the first and second samples.
4. The data recovery circuit of clause 2, wherein the accumulator is configured to accumulate miscompares between the values from the first and second samples.
5. The data recovery circuit of clause 3, wherein the accumulator is configured to accumulate miscompares between the values from the first and second samples with the sampling phase and tracking phase set to adjacent clock phase signals.
6. The data recovery circuit of clause 3, wherein the control module is further configured to analyze the accumulated miscompares to determine a phase corresponding to zero crossing of the received data signal, and set the sampling phase to correspond to a phase offset by one half of a data interval from the determined phase.
7. The data recovery circuit of clause 3, wherein the control module is further configured to analyze the accumulated miscompares to determine a phase corresponding to max crossing of the received data signal, and set the sampling phase to correspond to the max crossing.
8. The data recovery circuit of clause 3, wherein the control module is further configured to set the tracking phase to phase that is offset from the sampling phase, accumulate miscompares between the first and second samples, and adjust the sampling phase based on the accumulated miscompares.
9. The data recovery circuit of clause 8, wherein adjusting the sampling phase comprises determining a new sampling phase, adjusting the tracking phase to the new sampling phase, waiting for a settling time, and then using the continuing to use the new sampling phase for use in recovering the received data signal.
10. The data recovery circuit of clause 9, wherein adjusting the sampling phase further comprises, selecting a new tracking phase and adjusting the sampling phase to the new tracking phase, then using the new tracking phase to track the received data signal after the settling period.
11. The data recovery circuit of clause 1, wherein the first and second sample generation blocks comprise first and second gates respectively.
12. A method for data recovery, comprising:
   generating a plurality of clock phase signals in a Phase Lock Loop (PLL);
   producing a first clock signal and a second clock signal from the plurality of clock phase signals, the first and second clock signals for use in acquiring and tracking a received data signal;
   generating a first sample of the received data signal under control of the first clock signals; generating a second sample of the received data signal under control of the second clock signal; and
   in a control module, controlling the phase select module so as to iteratively produce the first and second clock signals from pairs of the plurality of clock phase signals and comparing the first and second samples to acquire the received data signal and selecting one of the plurality of clock phase signals as a sampling phase for use in recovering the received data signal and selecting another one of the plurality of clock phase signals as a tracking phase for use in tracking the received data signal.
13. The method of clause 12, further comprising generating a first sample of the received data signal under control of the sampling phase and generating a second sample of the received data signal under control of the tracking phase.
14. The method of clause 12, further comprising accumulating the results of comparisons of the first and second samples.
15. The method of clause 13, further comprising accumulating miscompares between the values from the first and second samples.
16. The method of clause 14, further comprising accumulating miscompares between the values from the first and second samples with the sampling phase and tracking phase set to adjacent clock phase signals.
17. The method of clause 14, further comprising analyzing the accumulated miscompares to determine a phase corresponding to zero crossing of the received data signal, and setting the sampling phase to correspond to a phase offset by one half of a data interval from the determined phase.
18. The data recovery circuit of clause 14, further comprising analyzing the accumulated miscompares to determine a phase corresponding to max crossing of the received data signal, and setting the sampling phase to correspond to the max crossing.
19. The data recovery circuit of clause 14, wherein adjusting the sampling phase further comprises setting the tracking phase to phase that is offset from the sampling phase, accumulating miscompares between the first and second samples, and adjusting the sampling phase based on the accumulated miscompares.
20. The data recovery circuit of clause 19, wherein adjusting the sampling phase comprises determining a new sampling phase, adjusting the tracking phase to the new sampling phase, waiting for a settling time, and then using the continuing to use the new sampling phase for use in recovering the received data signal.
21. The data recovery circuit of clause 20, wherein adjusting the sampling phase further comprises, selecting a new tracking phase and adjusting the sampling phase to the new tracking phase, then using the new tracking phase to track the received data signal after the settling period.
22. A data recovery circuit, comprising:
   a Phase Lock Loop (PLL) configured to generate a plurality of clock phase signals;
   a phase select module configured to produce a plurality of pairs of first clock signals and second clock signals from the plurality of clock phase signals, each pair of first and second clock signals for use in acquiring and tracking a plurality of received data signals;
   a plurality of pairs of first sample generation blocks each configured to generate a first sample of the corresponding received data signal under control of the first clock signal, and a plurality of pairs of second sample generation circuits each configured to generate a second sample of the corresponding received data signal under control of the second clock signal; and
   a control module coupled with the plurality of pairs of first and second sample generation blocks and the phase select module and configured to control the phase select module so as to iteratively produce the plurality of pairs of first and second clock signals from the plurality of clock phase signals and compare the corresponding first and second samples to acquire the corresponding received data signal and, for each received data signal and corresponding pair of first and second clock signals, to select one of the plurality of clock phase signals as a sampling phase for use in recovering the corresponding received data signal and to select another one of the plurality of clock phase signals as a tracking phase for use in tracking the received data signal.
23. The data recover circuit of clause 22, wherein for each of the plurality of pairs of first and second sample generation blocks, the first sample generation block is configured to generate a first sample of the received data signal under control of the sampling phase and the second sample generation block is configured to generate a second sample of the received data signal under control of the tracking phase.
24. The data recovery circuit of clause 22, wherein the control module further comprises an accumulator coupled each of the plurality of pairs of first and second sample generation blocks, the accumulator configured to accumulate the results of comparisons of the corresponding first and second samples.
25. The data recovery circuit of clause 24, wherein the accumulator is configured to accumulate miscompares between the values from the corresponding first and second samples.
26. The data recovery circuit of clause 24, wherein the accumulator is configured to accumulate miscompares between the values from the corresponding first and second samples with the sampling phase and tracking phase set to adjacent clock phase signals.
27. The data recovery circuit of clause 24, wherein the control module is further configured to analyze the accumulated miscompares to determine a phase corresponding to zero crossing of the corresponding received data signal, and set the sampling phase to correspond to a phase offset by one half of a data interval from the determined phase.
28. The data recovery circuit of clause 24, wherein the control module is further configured to analyze the accumulated miscompares to determine a phase corresponding to max crossing of the corresponding received data signal, and set the sampling phase to correspond to the max crossing.
29. The data recovery circuit of clause 24, wherein the control module is further configured, for each of the plurality of received data signals, to set the corresponding tracking phase to phase that is offset from the corresponding sampling phase, accumulate miscompares between the first and second samples, and adjust the sampling phase based on the accumulated miscompares.
30. The data recovery circuit of clause 29, wherein adjusting the sampling phase comprises determining a new sampling phase, adjusting the tracking phase to the new sampling phase, waiting for a settling time, and then using the continuing to use the new sampling phase for use in recovering the received data signal.
31. The data recovery circuit of clause 30, wherein adjusting the sampling phase further comprises, selecting a new tracking phase and adjusting the sampling phase to the new tracking phase, then using the new tracking phase to track the received data signal after the settling period.
32. A method for data recovery, comprising:
   generating a plurality of clock phase signals in a Phase Lock Loop (PLL);
   producing a first clock signal and a second clock signal from the plurality of clock phase signals, the first and second clock signals for use in acquiring and tracking a received data signal;
   generating a first sample of the received data signal under control of the first clock signals;
   generating a second sample of the received data signal under control of the second clock signal; and
   in a control module, controlling the phase select module so as to iteratively produce the first and second clock signals from pairs of the plurality of clock phase signals and comparing the first and second samples to acquire the received data signal and selecting one of the plurality of clock phase signals as a sampling phase for use in recovering the received data signal and selecting another one of the plurality of clock phase signals as a tracking phase for use in tracking the received data signal.
33. The method of clause 32, further comprising generating a first sample of the received data signal under control of the sampling phase and generating a second sample of the received data signal under control of the tracking phase.
34. The method of clause 32, further comprising accumulating the results of comparisons of the first and second samples.
35. The method of clause 33, further comprising accumulating miscompares between the values from the first and second samples.
36. The method of clause 34, further comprising accumulating miscompares between the values from the first and second samples with the sampling phase and tracking phase set to adjacent clock phase signals.
37. The method of clause 34, further comprising analyzing the accumulated miscompares to determine a phase corresponding to zero crossing of the received data signal, and setting the sampling phase to correspond to a phase offset by one half of a data interval from the determined phase.
38. The data recovery circuit of clause 33, further comprising analyzing the accumulated miscompares to determine a phase corresponding to max crossing of the received data signal, and setting the sampling phase to correspond to the max crossing.
39. The data recovery circuit of clause 33, wherein adjusting the sampling phase further comprises setting the tracking phase to phase that is offset from the sampling phase, accumulating miscompares between the first and second samples, and adjusting the sampling phase based on the accumulated miscompares.
40. The data recovery circuit of clause 39, wherein adjusting the sampling phase comprises determining a new sampling phase, adjusting the tracking phase to the new sampling phase, waiting for a settling time, and then using the continuing to use the new sampling phase for use in recovering the received data signal.
41. The data recovery circuit of clause 40, wherein adjusting the sampling phase further comprises, selecting a new tracking phase and adjusting the sampling phase to the new tracking phase, then using the new tracking phase to track the received data signal after the settling period.

## Claims

1. A data recovery circuit, comprising:
a Phase Lock Loop (PLL) configured to generate a plurality of clock phase signals;
a phase select module configured to produce a first clock signal and a second clock signal from the plurality of clock phase signals, the first and second clock signals for use in acquiring and tracking a received data signal;
a first sample generation block configured to generate a first sample of the received data signal under control of the first clock signals;
a second sample generation block configured to generate a second sample of the received data signal under control of the second clock signal; and
a control module coupled with the first and second sample generation blocks and the phase select module and configured to control the phase select module so as to iteratively produce the first and second clock signals from pairs of the plurality of clock phase signals and compare the first and second samples to acquire the received data signal and to select one of the plurality of clock phase signals as a sampling phase for use in recovering the received data signal and to select another one of the plurality of clock phase signals as a tracking phase for use in tracking the received data signal.

2. The data recover circuit of claim 1, wherein the first sample generation block is configured to generate a first sample of the received data signal under control of the sampling phase and the second sample generation block is configured to generate a second sample of the received data signal under control of the tracking phase.

3. The data recovery circuit of claim 1 or 2, wherein the control module further comprises an accumulator coupled with the first and second sample generation blocks, the accumulator configured to accumulate the results of comparisons of the first and second samples.

4. The data recovery circuit of claim 3, wherein the accumulator is configured to accumulate miscompares between:
a) the values from the first and second samples; or
b) the values from the first and second samples with the sampling phase and tracking phase set to adjacent clock phase signals.

5. The data recovery circuit of claim 4, wherein the control module is further configured to analyze the accumulated miscompares to determine a phase corresponding to:
a) zero crossing of the received data signal, and set the sampling phase to correspond to a phase offset by one half of a data interval from the determined phase; or
b) max crossing of the received data signal, and set the sampling phase to correspond to the max crossing.

6. The data recovery circuit of claim 4 or 5, wherein the control module is further configured to set the tracking phase to phase that is offset from the sampling phase, accumulate miscompares between the first and second samples, and adjust the sampling phase based on the accumulated miscompares.

7. The data recovery circuit of claim 6, wherein adjusting the sampling phase comprises:
a) determining a new sampling phase, adjusting the tracking phase to the new sampling phase, waiting for a settling time, and then using the new sampling phase for use in recovering the received data signal; or
b) determining a new sampling phase, adjusting the tracking phase to the new sampling phase, waiting for a settling time, and then using the new sampling phase for use in recovering the received data signal; wherein adjusting the sampling phase further comprises, selecting a new tracking phase and adjusting the sampling phase to the new tracking phase, then using the new tracking phase to track the received data signal after the settling period.

8. The data recovery circuit of any preceding claim, wherein the first and second sample generation blocks comprise first and second gates respectively.

9. A method for data recovery, comprising:
generating a plurality of clock phase signals in a Phase Lock Loop (PLL);
producing a first clock signal and a second clock signal from the plurality of clock phase signals, the first and second clock signals for use in acquiring and tracking a received data signal;
generating a first sample of the received data signal under control of the first clock signals;
generating a second sample of the received data signal under control of the second clock signal; and
in a control module, controlling the phase select module so as to iteratively produce the first and second clock signals from pairs of the plurality of clock phase signals and comparing the first and second samples to acquire the received data signal and selecting one of the plurality of clock phase signals as a sampling phase for use in recovering the received data signal and selecting another one of the plurality of clock phase signals as a tracking phase for use in tracking the received data signal.

10. The method of claim 9, further comprising generating a first sample of the received data signal under control of the sampling phase and generating a second sample of the received data signal under control of the tracking phase.

11. The method of claim 9 or 10, further comprising accumulating the results of comparisons of the first and second samples.

12. The method of claim 10 or 11, further comprising accumulating miscompares:
a) between the values from the first and second samples; or
b) between the values from the first and second samples with the sampling phase and tracking phase set to adjacent clock phase signals.

13. The method of claim 12, further comprising analyzing the accumulated miscompares to determine a phase corresponding to zero crossing of the received data signal, and setting the sampling phase to correspond to a phase offset by one half of a data interval from the determined phase.

14. The method of claim 12 or 13, wherein:
a) adjusting the sampling phase further comprises setting the tracking phase to phase that is offset from the sampling phase, accumulating miscompares between the first and second samples, and adjusting the sampling phase based on the accumulated miscompares; or
b) adjusting the sampling phase further comprises setting the tracking phase to phase that is offset from the sampling phase, accumulating miscompares between the first and second samples, and adjusting the sampling phase based on the accumulated miscompares; wherein adjusting the sampling phase comprises determining a new sampling phase, adjusting the tracking phase to the new sampling phase, waiting for a settling time, and then using the new sampling phase for use in recovering the received data signal; or
c) adjusting the sampling phase further comprises setting the tracking phase to phase that is offset from the sampling phase, accumulating miscompares between the first and second samples, and adjusting the sampling phase based on the accumulated miscompares; wherein adjusting the sampling phase comprises determining a new sampling phase, adjusting the tracking phase to the new sampling phase, waiting for a settling time, and then using the new sampling phase for use in recovering the received data signal; wherein adjusting the sampling phase further comprises, selecting a new tracking phase and adjusting the sampling phase to the new tracking phase, then using the new tracking phase to track the received data signal after the settling period.

15. The method of any one of claims 12 to 14, further comprising analyzing the accumulated miscompares to determine a phase corresponding to max crossing of the received data signal, and setting the sampling phase to correspond to the max crossing.
